# EUROPEAN PATENT SPECIFICATION

(11) **EP 3 949 685 B1**
(45) Date of publication and mention of the grant of the patent: **20.07.2022**
(21) Application number: 20711988.4
(22) Date of filing: 24.03.2020
(51) Int. Cl.: H01L 25/075, H01L 33/50, H05B 45/00

(54) **MULTI-LAYER PCB STACK FOR COLOR MIXING**
MEHRSCHICHTIGER LEITERPLATTENSTAPEL ZUR FARBMISCHUNG
EMPILEMENT PCB MULTICOUCHES DE MÉLANGE DE COULEURS

(30) Priority: 28.03.2019 EP 19165682
(43) Date of publication of application: 09.02.2022
(73) Proprietor: Signify Holding B.V., 5656 AE Eindhoven (NL)
(72) Inventor: VAN DER LUBBE, Marcellus, Jacobus, Johannes, 5656 AE Eindhoven (NL); TER WEEME, Berend, Jan, Willem, 5656 AE Eindhoven (NL)
(74) Representative: Verweij, Petronella Daniëlle
(86) International application number: PCT/EP2020/058204
(87) International publication number: WO 2020/193572

(56) References cited:
- US-A1- 2010 164 346
- US-A1- 2017 118 810
- US-A1- 2019 090 323

## Description

### FIELD OF THE INVENTION

The invention relates to a lighting device, a luminaire comprising such lighting device, and to a lighting system comprising such lighting device. The invention also relates to a method of providing such lighting device.

### BACKGROUND OF THE INVENTION

RGB-stack light emitting diode modules are known in the art. A paper by Ying-Chang Li et al. titled RGB-Stack Light Emitting Diode Modules with Transparent Glass Circuit Board and Oil Encapsulation, Materials 2018, vol. 11, 65 (2018 Materials (Basel). Mar 1;11(3). pii: E365. doi: 10.3390/mal 1030365) indicates that the "light emitting diode (LED) is widely used in modern solid-state lighting applications, and its output efficiency is closely related to the submounts' material properties. Most submounts used today, such as low-power printed circuit boards (PCBs) or high-power metal core printed circuit boards (MCPCBs), are not transparent and seriously decrease the output light extraction. To meet the requirements of high light output and better color mixing, a three-dimensional (3-D) stacked flip-chip (FC) LED module is proposed and demonstrated. To realize light penetration and mixing, the mentioned 3-D vertically stacking RGB LEDs use transparent glass as FC package submounts called glass circuit boards (GCB). Light emitted from each GCB stacked LEDs passes through each other and thus exhibits good output efficiency and homogeneous light-mixing characteristics".

US2010/0164346A1 discloses an a light emitting device comprising a thermally conductive substrate, at least one LED mounted in thermal communication with a surface of the substrate; a housing attached to the substrate and configured such that the housing and substrate together define a volume that totally encloses the at least one LED. The housing comprises at least a part that is a light transmissive window, and at least one phosphor material provided on an inner surface of the housing being operable to absorb at least a part of the excitation light emitted by the at least one light emitting diode and to emit light of a second wavelength range.

### SUMMARY OF THE INVENTION

Spot lamps may be composed of a circuitry PCB board where the available space on the board may be occupied with driver electronics, light emitting diodes (LEDs), and routing tracks to close the circuit and apply electrical power. The LEDs are placed in the center of this PCB board to have the light emitting surface (LES), as small as possible. This LES determines the size of optical compounds needed to shape the light beam of the spot lamp. According to electronic and thermal rules these components, LEDs and routing may especially have a certain distance from each other e.g. to prevent electrical discharges or overheating of the components and LEDs. This may mean that part of the available space in the LES cannot be used for a lighting element. Only in simple light architectures, the routing allows a close together packed layout. When a multi-color architecture with e.g. red, green, blue and white LEDs is composed, the related routing will be much more complicated and may occupy a great deal of the available space to connect all different colors individually. It may be unavoidable that the routing may have to be placed in between adjacent LEDs which may enlarge the LED to LED distance substantially, and with that the LES of the complete architecture. Thereby, undesirably the etendue may be increased. Especially, when smaller sized LEDs may be used, the ratio of useful light emitting area, versus the total occupied area will increase. In case of the use of mini-LEDs, with typical sizes of Length × Width = 200um × 100um, the width of the routing wires may have about the same size as the mini-LED or may even exceed the width size of a mini-LED. In this case, the routing may occupy more space than needed for a LED itself and therefor a great benefit of using e.g. mini-LEDs may be lost.

Hence, it is an aspect of the invention to provide an alternative lighting device, which preferably further at least partly obviates one or more of above-described drawbacks. The present invention may have as object to overcome or ameliorate at least one of the disadvantages of the prior art, or to provide a useful alternative.

The invention relates to a lighting device according to claim 1 and to a method according to claim 15.

In embodiments, the invention provides amongst others a method where individual PCB boards, with each board containing a part of the total light architecture, are stacked on to each other and the boards combined may have the total intended architecture of the spot lamp. In a conventional method, the PCB could consist of a multi-layer PCB where the routing for connecting and addressing the individual LEDs take place over several layers. This may require a substantial amount of vias to connect all layers electrically. The extensive routing may consume a lot of space needed for thermal dissipation of the generated heat by the LEDs. However, with the proposed method - in specific embodiments - only single colors or a simple addressable combination of colors may be placed on one discrete PCB. This PCB may especially consist of one layer with a top face and a bottom face. On a second or a multiple amount of PCB boards other LEDs, parts of the total light architecture may in embodiments be mounted. Combining - in embodiments - the different PCB boards by stacking them on top of each other, the total architecture of the lamp becomes available. In embodiments, the alignment of the different PCBs can be done with pins and/or alignment marks, etc., and/or in combination with vias which connects the routing as well as the stack of PCB to each other. As in specific embodiments the LEDs may be placed on different levels, it leaves in embodiments the opportunity to partially cover LEDs with phosphor. In embodiments, this could be done by a phosphor foil and/or in embodiments a phosphor deposition on, in yet further specific embodiments the deepest layer in the stack.

Hence, in an aspect the invention provides a lighting device comprising a multi-layer PCB stack comprising n stacked layers, wherein n≥2. A plurality of the layers, i.e. k layers of the n stacked layers may each comprise a PCB, especially with a solid state light source, especially a plurality of solid state light sources (for each PCB). Especially, 2≤k≤n. Further, especially the(se) solid state light sources are configured to generate light source light. In specific embodiments, the layers are shaped and stacked such that the light source light of one of the PCBs is at least partly not physically blocked by one or more other PCBs. Therefore, especially the invention provides a lighting device comprising a multi-layer PCB stack comprising n stacked layers, wherein n≥2, wherein k layers of the n stacked layers each comprises a PCB with a solid state light source, especially a plurality of solid state light sources (for each PCB), wherein 2≤k≤n, wherein the solid state light sources are configured to generate light source light, wherein the layers are shaped and stacked such that the light source light of a light source of any of the PCBs is at least partly not physically blocked by any of the other PCBs by applying a smaller PCB in the layer (110) on the layer (110) comprising the solid state light source (10).

Such lighting device may allow a relatively simple production. Further, with such lighting device it may be possible to use a high density of light sources on each of the PCBs, as the routing (on each of the PCBs) may be simple. Hence, the LES may be reduced relative to known or alternative solutions and/or the production and/or construction may be relatively simple. For instance, it is not necessary to use transparent materials which may complicate production and/or construction. Further, it may be possible to control optical properties of the generated light, such as one or more of color point, color temperature, color rendering index, etc.

As indicated above, the invention provides a lighting device comprising a multi-layer PCB stack comprising n stacked layers. Hence, in embodiments two or more layers may be stacked. In more specific embodiments, e.g. two or more PCBs may be stacked. However, the stack may also comprise non-PCB layers.

When a layer comprises a PCB, the layer may comprise a single PCB. It may also be possible that a layer comprises a plurality of PCBs, especially all in the same plane (i.e. not stacked within the layer). Such plurality of PCBs, especially all in the same plane, may be functionally coupled. The invention is especially further elucidated with a plurality of PCBs in different layers, such as a stack of PCBs.

Two or more of the n layers may (each) comprise a PCB. Hence, k layers of the n stacked layers may each comprise a PCB. Hence, the lighting device comprises at least two PCBs in different layers. Each of the PCBs comprises a solid state light source, especially a plurality of solid state light sources. As two or more of the n layers may comprise a PCB, especially 2≤k≤n.

Here below, some embodiments in relation to PCBs are described. Different layers may comprise different embodiments of PCBs. Basic PCB aspects may be relevant for each PCB of the layer stack.

In embodiments, a PCB may comprise an insulating layer arranged between a substrate and a conductive layer. As known in the art, a printed circuit board may mechanically support and electrically connect electronic components or electrical components using conductive tracks, pads and other features etched from one or more sheet layers of copper laminated onto and/or between sheet layers of a non-conductive substrate (shortly indicated as "track" or "conductive track"). An (electronic) component, such as a solid stage light source, may generally be soldered onto the PCB to both electrically connect and mechanically fasten it to the PCB. For instance, a basic PCB may consist of a flat sheet of insulating material and a layer of copper foil, laminated to the substrate. Chemical etching divides the copper into separate conducting lines (called tracks or circuit traces or routings or routing tracks), pads for connections, vias to pass connections between layers of copper, and features such as solid conductive areas for EM shielding or other purposes. The tracks function as wires fixed in place and are insulated from each other by air and the board substrate material. The surface of a PCB may have a coating that protects the copper from corrosion and reduces the chances of solder shorts between traces or undesired electrical contact with stray bare wires. For its function in helping to prevent solder shorts, the coating is called solder resist.

Hence, the shape of a PCB may in general be plate-like. Especially, in embodiments the PCB may have a length and a width and a height, wherein an aspect ratio of the length and the height is at least 5, like in the range of 5-5000, like 10-2500, though larger (than 5000) may also be possible, and wherein an aspect ratio of the width and the height is at least 2, such as an aspect ratio of at least 5, like in the range of 5-5000, like 10-2500, though larger (than 5000) may also be possible. The terms "length", "width", and "height" may also refer to "largest length", "largest width", and "largest height", respectively. The PCB may especially have a rectangular cross-section (such as a square cross-section). The PCB may also have a circular shape. Hence, in embodiments the PCB may have a diameter and a height, wherein an aspect ratio of the diameter and the height is at least 5, like in the range of 5-5000, like 10-2500, though larger (than 5000) may also be possible.

The height (or thickness) of the PCB may in embodiments be selected from the range of 0.2-10 mm, such as 0.5-5 mm, like 1-2 mm, though thinner or thicker may also be possible. A height (or thickness) may even be below 1 mm, or even below 0.1 mm. The width of the PCB may in embodiments be selected from the range of 5-200 mm, such as 5-50 mm, though other dimensions may also be possible. The length of a single printed circuit board area may in embodiments e.g. be selected from the range of 10-50 mm, such as 15-40 mm, though other dimensions may also be possible. The length of the PCB, including a plurality of (connected) PCB areas, may in embodiments e.g. be selected from the range of 20-2000 mm, such as 20-1500 mm. A diameter of a single printed circuit board area may in embodiments e.g. be selected from the range of 10-50 mm, such as 15-40 mm, though other dimensions may also be possible. Hence, other dimensions than mentioned above may be possible as well.

A PCB may comprise one or more of a CEM-1 PCE, a CEM-3 PCE, a FR-1 PCE, a FR-2 PCB, a FR-3 PCB, a FR-4 PCB, and aluminum metal core PCB, especially one or more of a CEM-1 PCB, a CEM-3 PCB, a FR-1 PCB, and a FR4 PCB and an aluminum metal core PCB, more especially one or more of a CEM-1 PCB, a CEM-3 PCB, a FR-1 PCB.

In specific embodiments, the PCB may be flexible. For instance, in embodiments the lighting device may comprise a stack of flexible PCB foils. In other embodiments, however, the PCB may be (essentially) rigid.

In specific embodiments, the PCB may be double sided, i.e. that electrical components may be arranged at both sides of the PCB.

As amongst others indicated above, especially the PCBs are essentially not transmissive for visible light. This may especially indicate that the material of the PCBs is not light transmissive. Hence, the light source light of a light source is herein also especially not blocked by a light transmissive PCB. Hence, especially, the PCBs do in embodiments not comprise light transmissive material. Hence, light source light that would be perpendicularly illuminate a PCB will not be transmitted through (the height) of the PCB. Note that a PCB hole is of course transmissive for visible light.

The PCB may comprise a functional component functionally coupled to the board. In yet further embodiments, the functional component may comprise a solid state light source. The term "functional component" may also refer to a plurality of (different) functional components. In further embodiments, the functional component may comprise an electronic component (or "electrical component"), especially an electronic component selected from the group comprising a solid state light source, a driver, an electronic module, and a sensor. Especially, the electronic component may comprise a solid state light source.

The term "light source" may refer to a semiconductor light-emitting device, such as a light emitting diode (LEDs), a resonant cavity light emitting diode (RCLED), a vertical cavity laser diode (VCSELs), an edge emitting laser, etc... The term "light source" may also refer to an organic light-emitting diode, such as a passive-matrix (PMOLED) or an active-matrix (AMOLED). In a specific embodiment, the light source comprises a solid state light source (such as a LED or laser diode). In an embodiment, the light source comprises a LED (light emitting diode). The term LED may also refer to a plurality of LEDs. The term "light source" may also relate to a plurality of (essentially identical (or different)) light sources, such as 2-2000 solid state light sources.

The phrases "different light sources" or "a plurality of different light sources", and similar phrases, may in embodiments refer to a plurality of solid state light sources selected from at least two different bins. Likewise, the phrases "identical light sources" or "a plurality of same light sources", and similar phrases, may in embodiments refer to a plurality of solid state light sources selected from the same bin.

Each PCB may comprise or functionally be coupled to at least a single solid state light source. The phrase "PCB comprising a solid state light source" and similar phrases may refer to embodiments wherein the PCB comprises the solid state light source or wherein the solid state light source is functionally coupled to the PCB. In both embodiments, the functional coupling may refer to the fact that the routing comprised by the PCB may provide electrical power to the solid state light source.

In general, however, each PCB may comprise or may functionally be coupled to a plurality of solid state light sources, such as at least 2, like at least 4, such as at least 8, like at least 16, such as at least 32, like at least 64. Note that the number of solid state light sources may independently be selected for each of the PCBs of the (k) different layers.

Hence, the phrase "a PCB with a solid state light source" and similar phrases may refer to a PCB with one or more light sources, in embodiments especially to a PCB with a plurality of light sources.

Herein, the term "light source" especially refers to a solid state light source, especially a small solid state light source, such as having a mini size or micro size. For instance, the light sources may comprise one or more of mini LEDs (or "miniLEDs") and micro LEDs (or "microLEDs" or "µLEDs"). Especially, in embodiment the light sources comprise mini LEDs. Herein, the term mini size or mini LED especially indicates to solid state light sources having dimensions, such as die dimension, especially length and width, selected from the range of equal to or less than about 1 mm, such as selected from the range of 100 µm - 1 mm. Herein, the term µ size or micro LED especially indicates to solid state light sources having dimensions, such as die dimensions, especially length and width, selected from the range of 100 µm and smaller. Further, in embodiments the solid state light sources may comprise dies having die areas (A) of at maximum 1 mm². For instance, in embodiments the solid state light sources comprise dies having die areas (A) of at maximum 0.04 mm² (e.g. 200 µm ^{∗} 200 µm), such as maximum 0.01 mm² (e.g. 100 µm ^{∗} 100 µm).

Especially, the solid state light sources are configured to generate light source light. In specific embodiments, the light source light that is generated by the light sources is the primary light of the solid state light source. Hence, the term "light source light" may refer to light (directly) emanating from a die, such as a LED die. Electrons in a (semiconductor) solid state light source may recombine with electron holes, releasing energy in the form of photons. This effect is called electroluminescence. Hence, the term "light source light" may especially refer to electroluminescence from the solid state light source; this light is herein also indicated as "primary light". Primary light may in embodiments at least partly be converted into secondary light by a luminescent material (see also below). As especially solid state light sources are applied, the light source light of the respective solid state light sources may essentially be monochromatic. Light sources within the same bin may essentially have the same peak wavelengths (such as with a variation within 10 nm). Further, light sources within the same bin may essentially have the same dominant wavelengths (such as with a variation within 10 nm). Light sources from different bins may e.g. have different colors (see further also below).

As a simple stacking of identical PCBs with light sources may result in blocking of light sources configured upstream by downstream configured light sources, a solution may have to be found for this problem. Hence, in the present invention especially the layers are shaped and stacked such that the light source light of one of the PCBs is at least partly not physically blocked by one or more other PCBs.

The terms "upstream" and "downstream" relate to an arrangement of items or features relative to the propagation of the light from a light generating means (here the especially the light source), wherein relative to a first position within a beam of light from the light generating means, a second position in the beam of light closer to the light generating means is "upstream", and a third position within the beam of light further away from the light generating means is "downstream".

As indicated above, the light sources may physically not blocked by (a) downstream configured PCB(s) by applying a small(er) PCB in the layer on the layer comprising the solid state light source (i.e. downstream of the layer comprising the solid state light source), such that the PCB does not block, or at least does not partially block the light source (light), and optionally applying a PCB (in the layer on the layer comprising the solid state light source), comprising a PCB hole such that the PCB does not block, or at least does not partially block the light source (light) (as the PCB hole is configured downstream of the light source. Hence, in embodiments one or more layers configured downstream of a first light source include one or more PCBs with one or more PCB holes, wherein the one or more PCB holes are configured downstream of the first light source. Hence, in embodiments, one or more layers configured downstream of a first solid state light source include one or more PCB's that have a smaller size in the longitudinal direction than the PCB comprising the first solid state light source.

In specific embodiments, the light sources may physically not blocked by (a) downstream configured layer(s) by applying a small(er) layer than the layer comprising the solid state light source, such that the layer does not block, or at least does not partially block the light source (light), and optionally applying a layer comprising a layer hole such that the layer does not block, or at least does not partially block the light source (light) (as the layer hole is configured downstream of the light source. Hence, in embodiments one or more layers configured downstream of a first light source comprise one or more layer holes, wherein the one or more layer holes are configured downstream of the first light source. However, in other specific embodiments PCB holes may be applied but also luminescent layers may be applied; the former may (essentially) not block the light source light, whereas the latter may physically block the light and convert part of the light source light.

Hence, the term "block" and similar terms may especially refer to the presence of solid material downstream of the light source. Such solid material is especially not available in the form of a PCB (by providing e.g. a PCB hole). Such solid material is thus especially also not available in the form of a light transmissive PCB material. In specific embodiments however, luminescent material, in the form of e.g. a (luminescent) layer, may be available. Hence, especially PCBs may not (essentially) block light sources, whereas layers or layer parts not being PCBs may in specific embodiments block the light source when they comprise luminescent material or are transmissive for the light source light.

Hence, the layers are shaped and stacked such that the light source light of a light source of any of the PCBs is at least partly not physically blocked by any of the other PCBs. The phrase "light source light of a light source of any of the PCBs is at least partly not physically blocked by any of the other PCBs" and similar phrases may in embodiments indicate that an optical axis of the light source does not coincide partly with a downstream configured PCB.

Hence, in this way PCB stacks may be provided that may have one or more step profiles. Such step profiles may be obtained by one or more of (i) using different sized layers, such as different sized PCBs, with in general the smaller (layers or PCBs, respectively) configured on the larger (layers or PCBs, respectively), and (ii) using one or more layers with one or more layer holes, such as one or more PCBs with one or more PCB holes. In the latter embodiment(s) the layers (or PCBs respectively), may have essentially the same external dimensions (in the plane parallel to the layers), though in other embodiments they may also differ (as the two embodiments may also be combined).

In embodiments, the one or more of the layers may essentially be PCB. In such embodiments, the layer hole(s) may essentially be PCB hole(s).

The layers may in embodiments be numbered L1-Ln, n≥2. Hence, when n=2, there is a first layer L1 and a second layer L2. When n=3, there is a first layer LI, a second layer L2, and a third layer L3; etc... Therefore, in embodiments the PCBs may be shaped and stacked such that a higher numbered PCB does not physically block at least part of the light source light of a light source of a lower numbered PCB.

With the present lighting device, it is also possible to have driver electronics on a single layer, such as a single PCB. These driver electronics may drive all light sources of the lighting device. Therefore, in embodiments the lighting device may further comprise driver electronics, wherein the driver electronics are configured to control one or more, especially all, solid state light sources. A "driver" or "driver electronics" may especially be an electrical circuit or other electronic component used to control another circuit or electrical component, such as a solid state light source or other electrical component, such as a high-power transistor. They are usually used to regulate current flowing through a circuit or to control other factors such as other components, some devices in the circuit. The term is often used, for example, for a specialized integrated circuit that controls an electrical component, such as a solid state light source. In specific embodiments, the driver electronics are comprised by or physically coupled to one of the n stacked layers, especially one of the PCBs.

Therefore, in embodiments the lighting device may further comprising one or more vias for functionally coupling the light sources and the driver electronics. In embodiments, vias may be used to electrically connect routings of adjacent PCBs. The term "routing" especially refers to electrically conductive tracks, e.g. to power the solid state light source(s) and/or other electrical components. Note that one or more of the PCBs may also comprise other electrical components. Instead of the term "electrical component" also the term "electronic component" may be applied.

The electronic component may include an active or a passive electronic component. An active electronic component may be any type of circuit component with the ability to electrically control electron flow (electricity controlling electricity). Examples thereof are diodes, especially light emitting diodes (LED). LEDs are herein also indicated with the more general term solid state lighting devices or solid state light sources. Hence, in embodiments the electronic component comprises an active electronic component. Especially, the electronic component comprises a solid state light source (see also above). Other examples of active electronic components may include power sources, such as a battery, a piezo-electric device, an integrated circuit (IC), and a transistor. In yet other embodiments, the electronic component may include a passive electronic component. Components incapable of controlling current by means of another electrical signal are called passive devices. Resistors, capacitors, inductors, transformers, etc. can be considered passive devices. In an embodiment, the electronic component may include an RFID (Radiofrequency identification) chip. A RFID chip may be passive or active. Especially, the electronic component may include one or more of a solid state light source (such as a LED), a RFID chip, and an IC. The term "electronic component" may also refer to a plurality of alike or a plurality of different electronic components.

The invention may especially be useful when applying small solid state light sources, even more especially a plurality of small solid state light sources. As indicated above, each PCB may comprise or may functionally be coupled to a plurality of solid state light sources, such as at least 2, like at least 4, such as at least 8, like at least 16, such as at least 32, like at least 64. Hence, in embodiments each of the k layers comprise a plurality of light sources.

Further, the invention may also especially be useful when applying a plurality of different types of solid state light sources. The term "different types" may especially refer to different bins. Hence, in embodiments there may be a plurality of light sources, in general a plurality of subsets of light sources, wherein the light sources of different subsets mutually differ in peak wavelength.

For instance, the differences between peak wavelengths of different subsets may be at least 20 nm. For instance, different subsets may provide light in different colors, such as blue, green, yellow, orange, and red. In embodiments, one or more subsets may also provide light in the violet or in the cyan. Further, within those colors there may be subranges, like deep red and far red. The terms "violet light" or "violet emission" especially relates to light having a wavelength in the range of about 380-440 nm. The terms "blue light" or "blue emission" especially relates to light having a wavelength in the range of about 440-495 nm (including some violet and cyan hues). The terms "green light" or "green emission" especially relate to light having a wavelength in the range of about 495-570 nm. The terms "yellow light" or "yellow emission" especially relate to light having a wavelength in the range of about 570-590 nm. The terms "orange light" or "orange emission" especially relate to light having a wavelength in the range of about 590-620 nm. The terms "red light" or "red emission" especially relate to light having a wavelength in the range of about 620-780 nm. Deep red may be defined as one or more wavelengths selected from the spectral range of 640-700 nm, and far-red may be defined as one or more wavelengths selected from the spectral range of 700-800 nm. Deep-red is thus a sub selection of red. The light sources are especially configured to generate visible light, though in embodiments (additional) UV and/or additional IR light may also be generated. The terms "visible", "visible light" or "visible emission" and similar terms refer to light having one or more wavelengths in the range of about 380-780 nm. The term "white light" herein, is known to the person skilled in the art. It especially relates to light having a correlated color temperature (CCT) between about 2000 and 20000 K, especially 2700-20000 K, for general lighting especially in the range of about 2700 K and 6500 K, and especially within about 15 SDCM (standard deviation of color matching) from the BBL (black body locus), especially within about 10 SDCM from the BBL, even more especially within about 5 SDCM from the BBL.

Hence, in embodiments there may be a plurality of light sources, in general a plurality of subsets light sources, wherein the light sources of different subsets mutually differ, especially in peak wavelength. In embodiments, at least two (especially each) of the k layers each comprise a subset of light sources of the respective plurality of light sources, wherein the light sources within each respective subset are selected from a same bin, and wherein the light sources of different subsets of different layers are selected from different bins.

Hence, in embodiments PCBs of different layers may generate light source light having different peak wavelengths, such RGB generated in three different layers. Note that it is herein not excluded that a single layer may also comprise e.g. two types of different solid state light sources. In general, however, each PCB comprises at maximum two different types of different solid state light sources. In yet more specific embodiments, one or more PCBs each comprise solid state light sources of the same bin (but different PCBs comprise light sources of different bins). Especially, most benefit of the invention may be reached when each PCB comprises a maximum of two different types of solid state light sources (i.e. in embodiments solid state light sources of different bins). For instance, peak wavelengths between different subsets may differ at least 10 nm, such as at least 20 nm, like at least 25 nm.

As indicated above, the solid state light source(s) in general only provide the primary wavelength, and do not comprise luminescent material. However, one or more of the solid state light sources may be applied in combination with a luminescent material. Hence, in embodiments the lighting device may further comprising a luminescent material configured downstream of one or more of the total number of solid state light sources, wherein the luminescent material is configured to convert at least part of the light source light of the solid state light sources configured upstream of the luminescent material into luminescent material light. The term "luminescent material" may also refer to a plurality of different luminescent materials. The same or different luminescent material may also be applied - in embodiments - at different positions within the lighting device.

The phrase "luminescent material is configured to convert at least part of the light source light of the solid state light sources configured upstream of the luminescent material into luminescent material light" and similar phrases may indicate in embodiments that downstream of a single solid state light source, or in embodiments downstream of a subset smaller than the total number of light sources, or even in specific embodiments downstream of all solid state light sources, a luminescent material may be configured. Further, such phrase and similar phrases may indicate that part of the light source light may be converted, and thus part of the light source light may also not be converted. This may lead to a combination of light source light and luminescent material light downstream of the luminescent material. In yet other embodiments, essentially all light source light may be converted (not considering possible losses due to e.g. conversion into thermal energy). Especially, the luminescent material is provided in a layer, where upstream thereof the solid state light source(s) are configured, and luminescent material may emanate (away) from the luminescent material at a downstream side of the luminescent material. In further specific embodiments, the luminescent material may be provided as layer that is also transmissive for the solid state light source light, whereby part is transmitted, and part is converted.

The luminescent material may be configured in a hole (over the one or more light sources upstream of the hole). The luminescent material may also be available as a layer (comprising the luminescent material). Hence, in embodiments one or more of the following applies: (i) the luminescent material is comprised by a PCB hole (as defined herein) downstream of the one or more of the total number of solid state light sources, and (ii) n>2, and one or more of the layers comprise the luminescent material. The luminescent material may be available in a layer, like a (plate-like) ceramic layer, or a polymeric layer.

Therefore, in specific embodiments the lighting device is configured to generate lighting device light which comprises one or more (i) of the light source light of one or more of the light sources and (ii) luminescent material light as defined herein.

Hence, in embodiments the n layers comprise two or more PCBs (with solid state light sources) and (optionally) one or more luminescent layers, wherein the two or more PCBs and the (optional) one luminescent layers are stacked. In specific embodiments the n layers essentially consist of two or more PCBs (with solid state light sources) and optionally one or more luminescent layers, wherein the two or more PCBs and the optional one luminescent layers are stacked. Especially, k=n, or k=n-1, or k=n-1 (with k especially at least being 2). The latter embodiments may refer to e.g. stackings of PCBs and one or two luminescent layers. Especially, k=n or k=n-1 (with k especially at least being 2).

Basically, there can be two types of embodiments; embodiments wherein the spectral properties of the lighting device light may not be tunable and embodiments wherein the spectral properties of the lighting device light is tunable. In the former embodiments, the lighting device light may be white, though colored light is not excluded. In the later embodiments, the lighting device may be configured to provide different types of light in different controlling modes (see also below), such as white light in a first controlling mode and colored light in a second controlling mode. Alternatively or additionally, the color point and/or color rendering index may be controlled in a (further) controlling mode.

In yet a further aspect, the invention also provides a luminaire comprising the lighting device as defined herein. The luminaire may further comprise a housing, optical elements, louvres, etc. etc.

The lighting device may be part of or may be applied in e.g. office lighting systems, household application systems, shop lighting systems, home lighting systems, accent lighting systems, spot lighting systems, theater lighting systems, fiber-optics application systems, projection systems, self-lit display systems, pixelated display systems, segmented display systems, warning sign systems, medical lighting application systems, indicator sign systems, decorative lighting systems, portable systems, automotive applications, (outdoor) road lighting systems, urban lighting systems, green house lighting systems, horticulture lighting, etc.

In an aspect, the invention provides a spotlight comprising the lighting device as defined herein. Especially, in such embodiment one or more of the PCBs may be round.

In yet a further aspect, the invention also provides a lighting system comprising (i) the lighting device as defined herein, and (ii) a control system, wherein the control system is configured to control the lighting device light, especially at least the spectral properties thereof. Hence, in specific embodiments, the control system may be configured to have the lighting device generate one or more of (a) white lighting system light in a first controlling mode, and (b) colored system light in a second controlling mode.

Note that the white light described herein may be based on different colors, such as RGB or other additive color mixing possibilities.

Therefore, in yet a further aspect, the invention also provides a lighting system comprising (i) the lighting device as defined herein, and (ii) a control system configured to control the driver electronics as defined herein, wherein the control system is configured to have the lighting device generate one or more of (a) white lighting system light in a first controlling mode, and (b) colored system light in a second controlling mode.

The phrase "one or more of (a) white lighting system light in a first controlling mode, and (b) colored system light in a second controlling mode" may amongst others indicate that the lighting system may in embodiments be configured to generate white light, the lighting system may in other embodiments be configured to generate colored light, and may in embodiments indicate that the system may be configured to provide both types of light in different controlling modes.

The term "controlling", and similar terms especially refer at least to determining the behavior or supervising the running of an element. Hence, herein "controlling" and similar terms may e.g. refer to imposing behavior to the element (determining the behavior or supervising the running of an element), etc., such as e.g. measuring, displaying, actuating, opening, shifting, changing temperature, etc. Beyond that, the term "controlling", and similar terms may additionally include monitoring. Hence, the term "controlling", and similar terms may include imposing behavior on an element and also imposing behavior on an element and monitoring the element. The controlling of the element can be done with a control system, which may also be indicated as "controller". The control system and the element may thus at least temporarily, or permanently, functionally be coupled. The element may comprise the control system. In embodiments, the control system and element may not be physically coupled. Control can be done via wired and/or wireless control. The term "control system" may also refer to a plurality of different control systems, which especially are functionally coupled, and of which e.g. one control system may be a master control system and one or more others may be slave control systems. A control system may comprise or may be functionally coupled to a user interface.

The control system may also be configured to receive and execute instructions form a remote control. In embodiments, the control system may be controlled via an App on a device, such as a portable device, like a Smartphone or I-phone, a tablet, etc... The device is thus not necessarily coupled to the lighting system but may be (temporarily) functionally coupled to the lighting system.

Hence, in embodiments the control system may (also) be configured to be controlled by an App on a remote device. In such embodiments the control system of the lighting system may be a slave control system or control in a slave mode. For instance, the lighting system may be identifiable with a code, especially a unique code for the respective lighting system. The control system of the lighting system may be configured to be controlled by an external control system which has access to the lighting system based on knowledge (input by a user interface of with an optical sensor (e.g. QR code reader) of the (unique) code. The lighting system may also comprise means for communicating with other systems or devices, such as based on Bluetooth, Wi-Fi, ZigBee, BLE or WiMAX, or another wireless technology.

The system, or apparatus, or device may execute an action in a "mode" or "operation mode" or "mode of operation". Likewise, in a method an action or stage, or step may be executed in a "mode" or "operation mode" or "mode of operation". The term "mode" may also be indicated as "controlling mode". This does not exclude that the system, or apparatus, or device may also be adapted for providing another controlling mode, or a plurality of other controlling modes. Likewise, this may not exclude that before executing the mode and/or after executing the mode one or more other modes may be executed.

However, in embodiments a control system may be available, that is adapted to provide at least the controlling mode. Would other modes be available, the choice of such modes may especially be executed via a user interface, though other options, like executing a mode in dependence of a sensor signal or a (time) scheme, may also be possible. The operation mode may in embodiments also refer to a system, or apparatus, or device, that can only operate in a single operation mode (i.e. "on", without further tunability).

Hence, in embodiments, the control system may control in dependence of one or more of an input signal of a user interface, a sensor signal (of a sensor), and a timer. The term "timer" may refer to a clock and/or a predetermined time scheme.

The control system may in embodiments control the subsets of light sources individually. In this way, one or more of intensity, color point, color temperature, color rendering of the lighting device light may be controlled.

In embodiments, different subsets may be configured to provide light source light having different spectral distributions. Hence, in embodiments two or more different subsets comprise light sources from two or more, respectively, different bins. For instance, in embodiments two or more different subsets comprise light sources configured to provide different types of colored light selected form e.g. the group consisting of blue, cyan, green, yellow, orange, and red (and optionally other colors). In this way, e.g. color point, color temperature, color rendering of the lighting device light may be controlled (with a control system controlling the subsets).

The lighting device may be provided by stacking layers, such as stacking PCBs. The layers may be provided with holes before stacking, or may be provided as layers with holes. Holes may also effectively be created by stacking smaller layers on larger layers, such as stacking smaller PCBs on larger PCB.

In yet a further, aspect, the invention also provides a method of providing a lighting device, such as especially the lighting device as defined herein, the method comprising stacking n layers, wherein n≥2, wherein k layers of the n stacked layers each comprises a PCB with a solid state light source, wherein 2≤k≤n, wherein the solid state light sources are configured to generate light source light. One or more of the following applies: (i) one or more of the k layers comprise one or more layer holes, and (ii) creating in a hole creation stage one or more layer holes in one or more of the k layers of the n stacked layers after the stacking. Further, the following applies: (iii) stacking of the n layers, and (iv) the optional layer hole creation of the layer holes in the hole creation stage is such that due to alignment of the light sources and the layer holes the light source light of a light source of any of the PCBs is at least partly not physically blocked by any of the other PCBs. A smaller PCB in the layer (110) on the layer comprising the solid state light source is applied The invention also provides in an aspect the lighting device obtainable according to the herein described method.

In yet a further embodiment, PCBs without solid state light sources may be stacked, to provide the PCB stack, and then (thus after the stacking) the solid state light sources may functionally be coupled with the respective PCBs.

### BRIEF DESCRIPTION OF THE DRAWINGS

Embodiments of the invention will now be described, by way of example only, with reference to the accompanying schematic drawings in which corresponding reference symbols indicate corresponding parts, and in which:
Figs. 1a-1b schematically depict some aspects of the invention;
Figs. 2a-2e schematically depict some (further) aspects of the invention;
Fig. 3 schematically depicts a lighting system and other aspects.

The schematic drawings are not necessarily to scale.

### DETAILED DESCRIPTION OF THE EMBODIMENTS

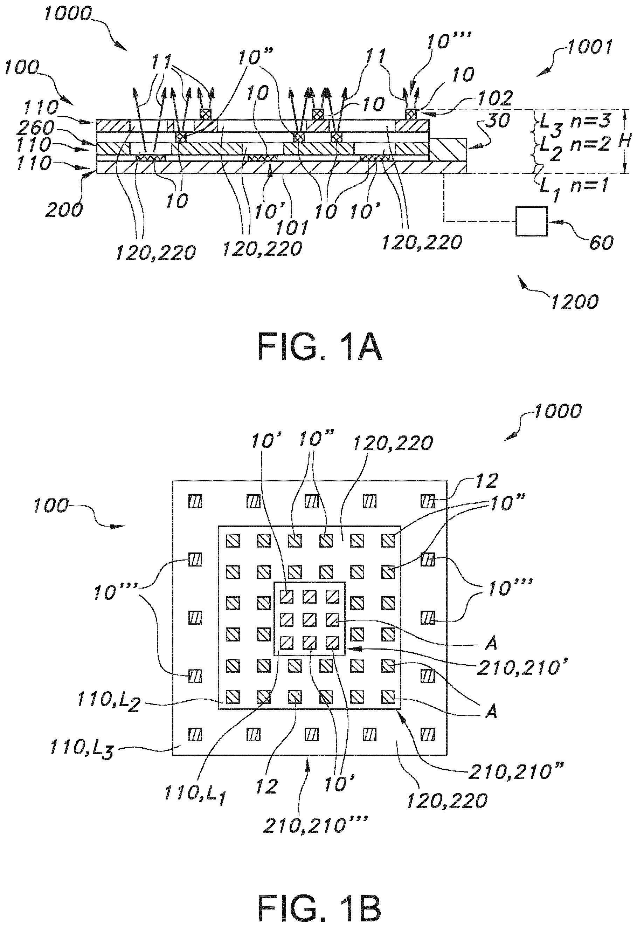

Fig. 1a schematically depicts - in a cross-sectional view - an embodiment of a lighting device 1000 comprising a multi-layer PCB stack 100 comprising n stacked layers 110, wherein n≥2. Here, by way of example n=3. Further, k layers 110 of the n stacked layers 110 each comprises a PCB 200 with a solid state light source 10, wherein 2≤k≤n. Here, k is also 3. Note that k is not necessarily n, but k is especially at least 2. Three layers 110 (or levels) are depicted, indicated with references LI, L2, and L3. The solid state light sources 10 are configured to generate light source light 11.

The layers 110 are shaped and stacked such that the light source light 11 of a light source 10 of any of the PCBs 200 is at least partly not physically blocked by any of the other PCBs 200. Hence, a kind of pyramid like structures are provided, with in embodiments at the steps solid state light sources.

As schematically depicted PCBs 200 of higher numbered layers 110 do not physically block at least part of the light source light 11 of a light source 10 of another PCB 200 due to alignment of the one or more layer holes 120 in the one or more higher numbered layers 110 and the solid state light sources 10 in the layers. Hence, in embodiments the light source light 11 of a light source 10 of any of the PCBs 200 is at least partly not physically blocked by any of the other PCBs 200. Especially, in embodiments the layers 110 may be shaped and stacked such that a higher numbered layer 110 does not physically block at least part of the light source light 11 of a light source 10 of a lower numbered layer 110.

The layer stack 100 may have a height H. Especially, a first layer L1 may have a first side 101 and an nth layer n may provide a second side 102. The first side 101 and the second side may define the height H of the multi-layer PCB stack 100. The light sources 10 may be considered to be comprised by the PCBs (and thus by the layers 110).

As shown, one or more layers 110 configured downstream of first light sources 10 comprise one or more layer holes 120, wherein the one or more layer holes 120 are configured downstream of the first light sources 10 (indicated with references 10' for light sources in the first layer 110 / L1 and indicated with references 10" in the second layer 100 / L2 (the light sources of the third layer 110 may be indicated with reference 10‴; however, these light sources are not blocked by a layer and/or PCB). Further, as shown one or more layers 110 configured downstream of first light sources 10 include one or more PCBs 200 with one or more PCB holes 220, wherein the one or more PCB holes 220 are configured downstream of the respective first light sources 10. Here, in this schematically depicted embodiment the layer holes 120 are (essentially) the same as the PCB holes 220. Hence, e.g. optical axis from the light sources 10 indicated with reference 10' or light sources 10 indicated with reference 10" are at least partly not physically "blocked" by one or more other PCBs. These axes do not partly coincide with a PCB, as there are PCB holes 220 (or layer holes).

The lighting device 1000 may further comprise driver electronics 30. In embodiments, the driver electronics 30 are especially configured to control all solid state light sources 10. Here, an embodiment is schematically depicted wherein the driver electronics 30 are comprised by or physically coupled to one of the n stacked layers 110.

As schematically depicted, here each of the k layers 110 comprise a plurality of light sources 10.

In specific embodiments at least two (more especially each) of the k layers 110 each comprise a subset of light sources 10 of the respective plurality of light sources 10. The light sources 10 within each respective subset may be selected from a same bin. Especially, the light sources 10 of different subsets of different layers 110 may be selected from different bins.

Fig. 1a effectively also schematically depict an embodiment of a lighting system 1200 comprising the lighting device 1000 and a control system 60. In embodiments, the control system 60 may be configured to control the driver electronics 30. Especially, in embodiments the control system 60 may be configured to have the lighting device 1000 generate one or more of (a) white lighting system light 1201 in a first controlling mode, and (b) colored system light 1201 in a second controlling mode.

Fig 1b schematically depicts an embodiment of a lighting device 1000 in top view. Three layers 110 (or levels) are depicted, indicated with references LI, L2, and L3. Each layer 110 comprises a PCB with light sources 10. Light sources 10 of different levels are differently hatched. The light sources of the layers are indicated with the level in between brackets, i.e. 10" indicates the light sources of the second layer 110 or L2 (PCB in the second layer 110). Note that in embodiments a kind of (inverted) pyramid shape may be provided. The second layer 110 or L2 and the third layer 110 or L3 provide holes 120 (or 220) for the light sources 10 (10') of the first layer 110 (LI), and for the light sources 10 of the first layer 110 (LI) (10') and second layer 110 (L2) (10"), respectively. Note that light sources 10 at different layers 110 may be configured to generate light source light having different spectral distributions. For instance, these three layers may generate RGB. However, other embodiments may also be possible (see also below).

Fig. 1b schematically also depicts the top faces of the solid state light sources 10, i.e. the dies. The solid state light sources 10 may thus comprise dies 12 having die areas A of e.g. at maximum 1 mm².

Such lighting device may e.g. be obtainable by a method comprising stacking n layers 110, wherein n≥2, wherein k layers 110 of the n stacked layers 110 each comprises a PCB 200 with a solid state light source 10, wherein 2≤k≤n, wherein the solid state light sources 10 are configured to generate light source light 11, wherein: (I) one or more of the following applies: (i) one or more of the k layers 110 comprise one or more layer holes 120, and (ii) creating in a hole creation stage one or more layer holes 120 in one or more of the k layers 110 of the n stacked layers 110 after the stacking; and (II) the following applies: (a) stacking of the n layers 110, and (b) the optional layer hole 120 creation of the layer holes 120 in the hole creation stage is such that due to alignment of the light sources 10 and the layer holes 120 the light source light 11 of a light source 10 of any of the PCBs 200 is at least partly not physically blocked by any of the other PCBs 200.

In specific embodiments at least two (more especially each) of the k layers 110 each comprise a subset 210 of light sources 10 of the respective plurality of light sources 10. The light sources 10 within each respective subset 210 may be selected from a same bin. Especially, the light sources 10 of different subsets 210 of different layers 110 may be selected from different bins, and may e.g. provide different colors, such as selected from blue, green, yellow, orange, and red. Here, by way of example each layer comprises a single subset, indicated with subsets 210', 210", and 210‴ respectively. Note however, that a layer 110 may also comprise more than one subset. In general, a layer 110, more precisely a PCB 200 will in general not comprise more than two different subset providing light source light 11 having more than two essentially different spectral distributions. Hence, in general a PCB may not comprise more than two, such as only one, type of light sources 10 (i.e. all from two or one bins). A control system (not shown), may control the different subsets individually.

With the proposed method only single colors or a simple addressable combination of colors may in (specific) embodiments be placed on one discrete PCB. On a second or a multiple amount of PCB boards other LEDs, parts of the total light architecture can be mounted. Combining the different PCB boards by stacking them on top of each other, the total architecture of the lamp becomes available. The alignment of the different PCB can in embodiments be done with pins or alignment marks in combination with vias which connects the routing as well as the stack of PCB to each other (see also below).

Indications 10', 10" and 10‴, etc. in e.g. Figs. 1a and 1b, but also other figures, do not necessarily indicate that these light sources belong to different subsets. This may be the case, but this is not necessarily the case. Further, the indication 10', or the indication 10", or the indication 10"', respectively, does not imply that all light sources indicated with such reference belong to the same subset. This may be the case, but this is not necessarily the case.

Different subsets may provide light source light with (essentially) different color points (and especially have the (essentially) different spectral distributions), but in other embodiments different subsets may provide light source light with (essentially) the same color points (and especially have the same spectral distributions).

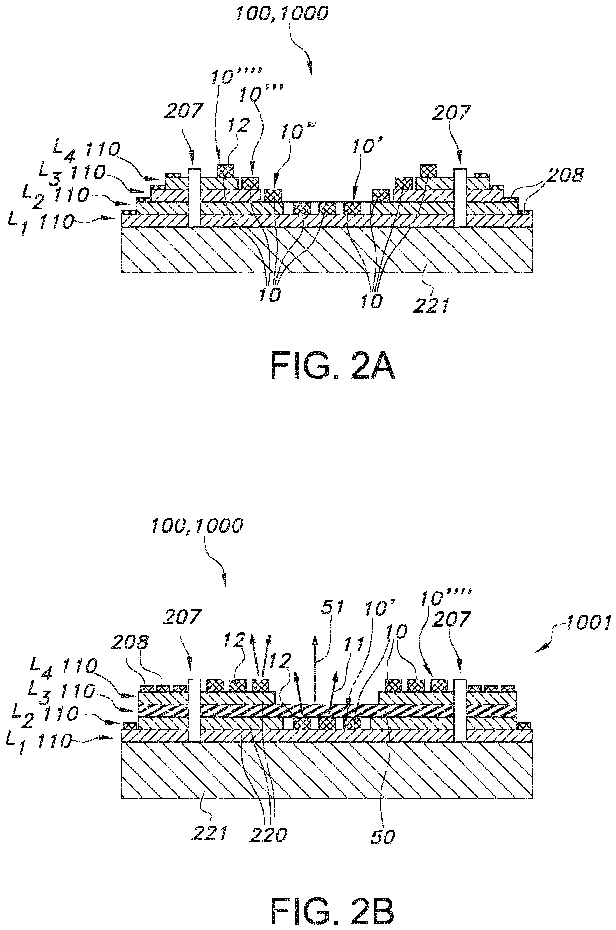

A further example is shown in Fig. 2a. Reference 207 refers to alignment pins. However, other alignment options, including adhesives, may also be applied. Reference 208 refers to a possible contact, for connection e.g. to driver electronics. Reference 221 indicates a support (such as a substrate).

Since the LEDs are placed on different levels, it leaves the opportunity to partially cover LEDs with phosphor. This could be done in embodiments by a phosphor foil or phosphor deposition, especially on the deepest layer in the stack. An example is shown in Fig. 2b, wherein the third layer 110 or L3 essentially comprises a luminescent material comprising layer.

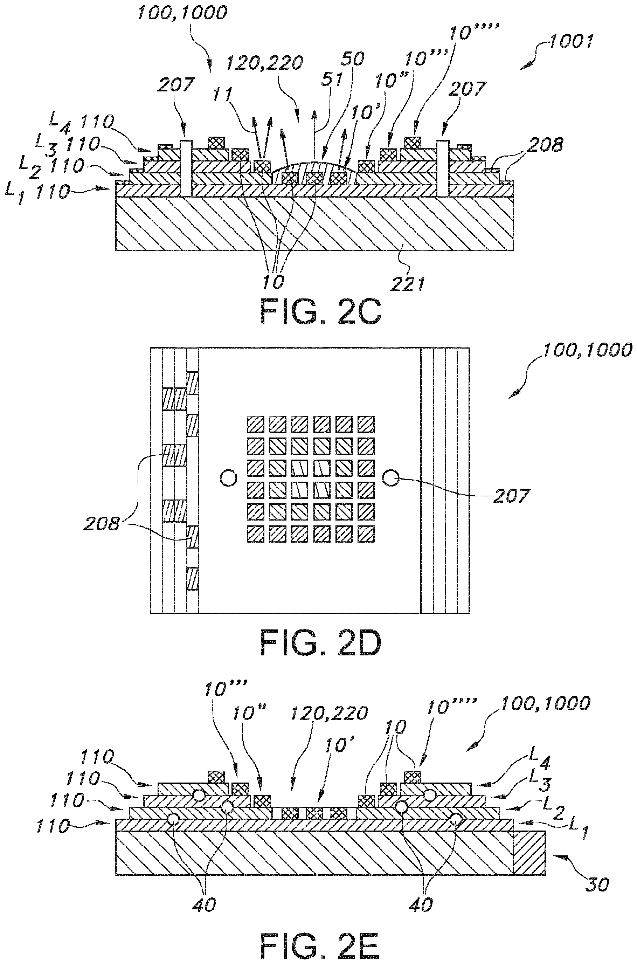

Another way of applying phosphor is phosphor deposition in the holes that are created by the stack of PCB layers, which is schematically depicted in Fig. 2c.

Referring to Figs. 2b and 2c, the lighting device 1000 may thus further comprise a luminescent material 50 configured downstream of one or more of the total number of solid state light sources 10. The luminescent material 50 is especially configured to convert at least part of the light source light 11 of the solid state light sources 10 configured upstream of the luminescent material 50 into luminescent material light 51. The luminescent material 50 may be comprised by a PCB hole 220 (downstream of the one or more of the total number of solid state light sources 10). Fig. 2b shows an embodiment wherein n>2, and one of the layers 110 comprise the luminescent material 50.

Amongst others in this way, the lighting device 1000 may in embodiments be configured to generate lighting device light 1001 which comprises one or more of the light source light 11 of one or more of the light sources 10 and luminescent material light 51.

Fig. 2d schematically depicts a top view of e.g. of the embodiment of Fig. 2a.

Other than with a multi-layer PCB where it is unavoidable that the routing takes a substantial amount of space near the LEDs to connect the individual LEDs, the proposed method to stack single PCBs to one module may give more room for placing LEDs with a different color in a small Light Emitting Surface. Dividing LEDs with a different color over several PCBs makes it possible to use a small Light Emitting Surface (LES). On each individual PCB one may be able to apply one or two color type of LEDs which makes the routing simple with none or a limited amount of vias and provide relative much space on the PCB for heat dissipation. Certainly, when mini LEDs are used or a combination standard LEDs with mini LEDs the architecture will benefit of this method. Using different heights in the placement of the LEDs enables the application of phosphor to a subset of the total LEDs. One can cover the LEDs on the deeper layers of the PCB, without affecting the ones on the top layers. In embodiments, every PCB part of the total stack of PCBs can be handled as a single layer PCB. This may allow Pick and Place equipment to work in a conventional way. Also applying a solder or adhesive can be done with conventional screen printing technology. After populating the individual PCBs which contains now part of the total light architecture are stacked. The base PCB which can contain LEDs and driver electronics is mounted on the heat sink of the spot lamp using the alignment pins. Every next layer PCB is placed on top of the base PCB and the former mounted PCB. Connecting the individual PCBs can be done with wire bond connections on the connect pads or any other technology such as using clips. Another way of connecting the individual PCBs is using vias which are part of the electrical routing. Here, e.g. solder ball preforms are placed during the stack assembly process and with a reflow solder the PCB layers are connected.

In yet a further embodiment, the PCBs without solid state light sources may be stacked, and then the solid state light sources may functionally be coupled with the respective PCBs.

Fig. 2e schematically depicts an embodiment further comprising one or more vias 40 for functionally coupling the light sources 10 and the driver electronics 30.

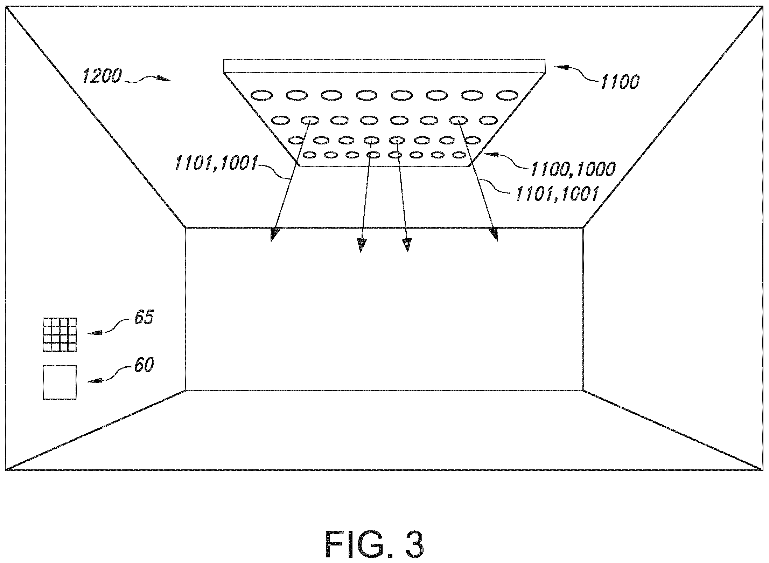

Fig. 3 schematically depicts an embodiment of a luminaire 1100 comprising the lighting device 1000. Further, Fig. 3 also schematically depicts an embodiment of a lighting system 1200 comprising the lighting device 1000. The lighting system 1200 may further comprise and a control system 60. The control system 30 may be configured to control the spectral distribution of the lighting device light 1001 (or luminaire light 1101 or lighting system light 1201, which may all essentially be identical; the lighting system light 1201 may be the lighting device light 1001). A lighting system 1200 may comprise a plurality of lighting devices 1000. Yet further, the lighting system 1000 may comprise a user interface 65, wherein the user interface 65 is functionally connected or connectable to the control system 60. Connection may be wireless or wired.

The term "plurality" refers to two or more.

The terms "substantially" or "essentially" herein, and similar terms, will be understood by the person skilled in the art. The terms "substantially" or "essentially" may also include embodiments with "entirely", "completely", "all", etc. Hence, in embodiments the adjective substantially or essentially may also be removed. Where applicable, the term "substantially" or the term "essentially" may also relate to 90% or higher, such as 95% or higher, especially 99% or higher, even more especially 99.5% or higher, including 100%.

The term "comprise" includes also embodiments wherein the term "comprises" means "consists of'.

The term "and/or" especially relates to one or more of the items mentioned before and after "and/or". For instance, a phrase "item 1 and/or item 2" and similar phrases may relate to one or more of item 1 and item 2. The term "comprising" may in an embodiment refer to "consisting of" but may in another embodiment also refer to "containing at least the defined species and optionally one or more other species".

Furthermore, the terms first, second, third and the like in the description and in the claims, are used for distinguishing between similar elements and not necessarily for describing a sequential or chronological order. It is to be understood that the terms so used are interchangeable under appropriate circumstances and that the embodiments of the invention described herein are capable of operation in other sequences than described or illustrated herein.

The devices, apparatus, or systems may herein amongst others be described during operation. As will be clear to the person skilled in the art, the invention is not limited to methods of operation, or devices, apparatus, or systems in operation.

It should be noted that the above-mentioned embodiments illustrate rather than limit the invention, and that those skilled in the art will be able to design many alternative embodiments without departing from the scope of the appended claims.

In the claims, any reference signs placed between parentheses shall not be construed as limiting the claim.

Use of the verb "to comprise" and its conjugations does not exclude the presence of elements or steps other than those stated in a claim. Unless the context clearly requires otherwise, throughout the description and the claims, the words "comprise", "comprising", and the like are to be construed in an inclusive sense as opposed to an exclusive or exhaustive sense; that is to say, in the sense of "including, but not limited to".

The article "a" or "an" preceding an element does not exclude the presence of a plurality of such elements.

## Claims

1. A lighting device (1000) comprising a multi-layer PCB stack (100) comprising n stacked layers (110), wherein n≥2, wherein k layers (110) of the n stacked layers (110) each comprise a PCB (200) with a solid state light source (10), wherein 2≤k≤n, wherein the solid state light sources (10) are configured to generate light source light (11), wherein the layers (110) are shaped and stacked such that the light source light (11) of the solid state light source (10) of any of the PCBs (200) is at least partly not physically blocked by any of the other PCBs (200) by applying a smaller PCB in the layer (110) on the layer (110) comprising the solid state light source (10).

2. The lighting device (1000) according to any one of the preceding claims, wherein one or more layers (110) configured downstream of a first light source (10) comprise one or more layer holes (120), wherein the one or more layer holes (120) are configured downstream of the first light source (10).

3. The lighting device (1000) according to any one of the preceding claims, wherein one or more layers (110) configured downstream of a first light source (10) include one or more PCBs (200) with one or more PCB holes (220), wherein the one or more PCB holes (220) are configured downstream of the first light source (10).

4. The lighting device (1000) according to any one of the preceding claims, further comprising driver electronics (30), wherein the driver electronics (30) are configured to control all solid state light sources (10).

5. The lighting device (1000) according to claim 4, wherein the driver electronics (30) are comprised by or physically coupled to one of the n stacked layers (110).

6. The lighting device (1000) according to any one of the preceding claims 4-5, further comprising one or more vias (40) for functionally coupling the light sources (10) and the driver electronics (30).

7. The lighting device (1000) according to any one of the preceding claims, wherein the solid state light sources (10) comprise dies (12) having die areas (A) of at maximum 1 mm².

8. The lighting device (1000) according to any one of the preceding claims, wherein each of the k layers (110) comprise a plurality of light sources (10).

9. The lighting device (1000) according to claim 8, wherein at least two of the k layers (110) each comprise a subset (210) of light sources (10) of the respective plurality of light sources (10), wherein the light sources (10) within each respective subset (210) are selected from a same bin, and wherein the light sources (10) of different subsets (210) of different layers (110) are selected from different bins.

10. The lighting device (1000) according to any one of the preceding claims, further comprising a luminescent material (50) configured downstream of one or more of the total number of solid state light sources (10), wherein the luminescent material (50) is configured to convert at least part of the light source light (11) of the solid state light sources (10) configured upstream of the luminescent material (50) into luminescent material light (51).

11. The lighting device (1000) according to claim 10, wherein one or more of the following applies: (i) the luminescent material (50) is comprised by a PCB hole (220) according to claim 3 downstream of the one or more of the total number of solid state light sources (10), and (ii) n>2, and one or more of the layers (110) comprise the luminescent material (50).

12. The lighting device (1000) according to any one of the preceding claims, wherein the lighting device (1000) is configured to generate lighting device light (1001) which comprises one or more (i) of the light source light (11) of one or more of the light sources (10) and (ii) luminescent material light (51) according to any one of the preceding claims 10-11.

13. A luminaire (1100) comprising the lighting device (1000) according to any one of the preceding claims 1-12.

14. A lighting system (1200) comprising (i) the lighting device (1000) according to any one of the preceding claims 1-12, and (ii) a control system (60) configured to control the driver electronics (30) according to any one of the preceding claims 4-6, wherein the control system (60) is configured to have the lighting device (1000) generate one or more of
(a) white lighting system light (1201) in a first controlling mode, and (b) colored system light (1201) in a second controlling mode.

15. A method of providing the lighting device (1000) according to any one of the preceding claims 1-12, the method comprising stacking n layers (110), wherein n≥2, wherein k layers (110) of the n stacked layers (110) each comprises a PCB (200) with a solid state light source (10), wherein 2≤k≤n, wherein the solid state light sources (10) are configured to generate light source light (11), wherein:
- one or more of the following applies: (i) one or more of the k layers (110) comprise one or more layer holes (120), and (ii) creating in a hole creation stage one or more layer holes (120) in one or more of the k layers (110) of the n stacked layers (110) after the stacking;
- the following applies: (iii) stacking of the n layers (110), and (iv) the optional layer hole (120) creation of the layer holes (120) in the hole creation stage is such that due to alignment of the light sources (10) and the layer holes (120) the light source light (11) of a light source (10) of any of the PCBs (200) is at least partly not physically blocked by any of the other PCBs (200),
- a smaller PCB in the layer (110) on the layer (11) comprising the solid state light source (10) is applied.

## Patentansprüche

1. Beleuchtungsvorrichtung (1000), umfassend einen mehrschichtigen Leiterplattenstapel (100), umfassend n gestapelte Schichten (110), wobei n≥2, wobei k Schichten (110) der n gestapelten Schichten (110) jeweils eine Leiterplatte (200) mit einer Festkörperlichtquelle (10) umfassen, wobei 2≤k≤n, wobei die Festkörperlichtquellen (10) zum Erzeugen von Lichtquellenlicht (11) konfiguriert sind, wobei die Schichten (110) so geformt und gestapelt sind, dass das Lichtquellenlicht (11) der Festkörperlichtquelle (10) einer der Leiterplatten (200) mindestens teilweise nicht physisch durch eine der anderen Leiterplatten (200) blockiert wird, indem eine kleinere Leiterplatte in der Schicht (110) auf der die Festkörperlichtquelle (10) umfassende Schicht (110) angebracht wird.

2. Beleuchtungsvorrichtung (1000) nach einem der vorstehenden Ansprüche, wobei eine oder mehrere stromabwärts von einer ersten Lichtquelle (10) konfigurierte Schichten (110) ein oder mehrere Schichtlöcher (120) umfassen, wobei das eine oder die mehreren Schichtlöcher (120) stromabwärts von der ersten Lichtquelle (10) konfiguriert sind.

3. Beleuchtungsvorrichtung (1000) nach einem der vorstehenden Ansprüche, wobei eine oder mehrere stromabwärts einer ersten Lichtquelle (10) konfigurierte Schichten (110) eine oder mehrere Leiterplatten (200) mit einem oder mehreren Leiterplattenlöchern (220) einschließen, wobei das eine oder die mehreren Leiterplattenlöcher (220) stromabwärts der ersten Lichtquelle (10) konfiguriert sind.

4. Beleuchtungsvorrichtung (1000) nach einem der vorstehenden Ansprüche, ferner umfassend Treiberelektronik (30), wobei die Treiberelektronik (30) zum Steuern aller Festkörperlichtquellen (10) konfiguriert ist.

5. Beleuchtungsvorrichtung (1000) nach Anspruch 4, wobei die Treiberelektronik (30) in einer der n gestapelten Schichten (110) umfasst oder physisch mit einer von diesen gekoppelt ist.

6. Beleuchtungsvorrichtung (1000) nach einem der vorstehenden Ansprüche 4 bis 5, ferner umfassend eine oder mehrere Durchkontaktierungen (40) zum funktionalen Koppeln der Lichtquellen (10) und der Treiberelektronik (30).

7. Beleuchtungsvorrichtung (1000) nach einem der vorstehenden Ansprüche, wobei die Festkörperlichtquellen (10) Chips (12) mit Chipflächen (A) von maximal 1 mm² umfassen.

8. Beleuchtungsvorrichtung (1000) nach einem der vorstehenden Ansprüche, wobei jede der k Schichten (110) eine Vielzahl von Lichtquellen (10) umfasst.

9. Beleuchtungsvorrichtung (1000) nach Anspruch 8, wobei mindestens zwei der k Schichten (110) jeweils einen Teilsatz (210) von Lichtquellen (10) der jeweiligen Vielzahl von Lichtquellen (10) umfassen, wobei die Lichtquellen (10) innerhalb jedes jeweiligen Teilsatzes (210) aus demselben Behälter ausgewählt sind, und wobei die Lichtquellen (10) verschiedener Teilsätze (210) verschiedener Schichten (110) aus verschiedenen Behältern ausgewählt sind.

10. Beleuchtungsvorrichtung (1000) nach einem der vorstehenden Ansprüche, ferner umfassend ein Lumineszenzmaterial (50), das stromabwärts von einer oder mehreren der Gesamtanzahl von Festkörperlichtquellen (10) konfiguriert ist, wobei das Lumineszenzmaterial (50) konfiguriert ist, um mindestens einen Teil des Lichtquellenlichts (11) der stromaufwärts des Lumineszenzmaterials (50) konfigurierten Festkörperlichtquellen (10) in Lumineszenzmateriallicht (51) umzuwandeln.

11. Beleuchtungsvorrichtung (1000) nach Anspruch 10, wobei eines oder mehrere der Folgenden gilt: (i) das Lumineszenzmaterial (50) wird durch ein Leiterplattenloch (220) nach Anspruch 3 stromabwärts von einer oder mehreren der Gesamtanzahl der Festkörperlichtquellen (10) gebildet, und (ii) n>2, und eine oder mehrere der Schichten (110) umfassen das Lumineszenzmaterial (50).

12. Beleuchtungsvorrichtung (1000) nach einem der vorstehenden Ansprüche, wobei die Beleuchtungsvorrichtung (1000) zum Erzeugen von Beleuchtungsvorrichtungslicht (1001) konfiguriert ist, das eines oder mehrere (i) des Lichtquellenlichts (11) einer oder mehrerer der Lichtquellen (10) und (ii) Lumineszenzmateriallicht (51) nach einem der vorstehenden Ansprüche 10 bis 11 umfasst.

13. Leuchte (1100), umfassend die Beleuchtungsvorrichtung (1000) nach einem der vorstehenden Ansprüche 1 bis 12.

14. Beleuchtungssystem (1200), umfassend (i) die Beleuchtungsvorrichtung (1000) nach einem der vorstehenden Ansprüche 1 bis 12 und (ii) ein Steuersystem (60), das zum Steuern der Treiberelektronik (30) nach einem der vorstehenden Ansprüche 4 bis 6 konfiguriert ist, wobei das Steuersystem (60) konfiguriert ist, um die Beleuchtungsvorrichtung (1000) zu veranlassen, eines oder mehrere von (a) weißem Beleuchtungssystemlicht (1201) in einem ersten Steuermodus und (b) farbigem System licht (1201) in einem zweiten Steuermodus zu erzeugen.

15. Verfahren zum Bereitstellen der Beleuchtungsvorrichtung (1000) nach einem der vorstehenden Ansprüche 1 bis 12, das Verfahren umfassend das Stapeln von n Schichten (110), wobei n≥2, wobei k Schichten (110) der n gestapelten Schichten (110) jeweils eine Leiterplatte (200) mit einer Festkörperlichtquelle (10) umfassen, wobei 2≤k≤n, wobei die Festkörperlichtquellen (10) zum Erzeugen von Lichtquellenlicht (11) konfiguriert sind, wobei:
- eines oder mehrere der Folgenden gilt: (i) eine oder mehrere der k Schichten (110) umfassen ein oder mehrere Schichtlöcher (120), und (ii) Erzeugen in einer Locherzeugungsstufe eines oder mehrerer Schichtlöcher (120) in einer oder mehreren der k Schichten (110) der n gestapelten Schichten (110) nach dem Stapeln;
- Folgendes gilt: (iii) das Stapeln der n Schichten (110), und (iv) die optionale Schichtlocherzeugung (120) der Schichtlöcher (120) in der Locherzeugungsstufe ist so, dass aufgrund der Ausrichtung der Lichtquellen (10) und der Schichtlöcher (120) das Lichtquellenlicht (11) einer Lichtquelle (10) einer der Leiterplatten (200) mindestens teilweise nicht durch eine der anderen Leiterplatten (200) physikalisch blockiert wird,
- es wird eine kleinere Leiterplatte in der Schicht (110) auf der die Festkörperlichtquelle (10) umfassende Schicht (11) angebracht.

## Revendications

1. Dispositif d'éclairage (1000) comprenant un empilement multicouche de PCB (100) comprenant n couches empilées (110), dans lequel n≥2, dans lequel k couches (110) des n couches empilées (110) comprennent chacune une PCB (200) avec une source de lumière à semi-conducteurs (10), dans lequel 2≤k≤n, dans lequel les sources de lumière à semi-conducteurs (10) sont configurées pour générer de la lumière de source de lumière (11), dans lequel les couches (110) sont profilées et empilées de telle sorte que la lumière de source de lumière (11) de la source de lumière à semi-conducteurs (10) de l'une quelconque des PCB (200) soit au moins partiellement non bloquée physiquement par l'une quelconque des autres PCB (200) en appliquant une plus petite PCB dans la couche (110) sur la couche (110) comprenant la source de lumière à semi-conducteurs (10).

2. Dispositif d'éclairage (1000) selon l'une quelconque des revendications précédentes, dans lequel une ou plusieurs couches (110) configurées en aval d'une première source de lumière (10) comprennent un ou plusieurs trous de couche (120), dans lequel le ou les trous de couche (120) sont configurés en aval de la première source de lumière (10).

3. Dispositif d'éclairage (1000) selon l'une quelconque des revendications précédentes, dans lequel une ou plusieurs couches (110) configurées en aval d'une première source de lumière (10) incluent une ou plusieurs PCB (200) avec un ou plusieurs trous de PCB (220), dans lequel le ou les trous de PCB (220) sont configurés en aval de la première source de lumière (10).

4. Dispositif d'éclairage (1000) selon l'une quelconque des revendications précédentes, comprenant en outre des composants électroniques de pilotage (30), dans lequel les composants électroniques de pilotage (30) sont configurés pour commander toutes les sources de lumière à semi-conducteurs (10).

5. Dispositif d'éclairage (1000) selon la revendication 4, dans lequel les composants électroniques de pilotage (30) sont compris par ou couplés physiquement à une des n couches empilées (110).

6. Dispositif d'éclairage (1000) selon l'une quelconque des revendications 4 à 5 précédentes, comprenant en outre un ou plusieurs trous d'interconnexion (40) pour coupler fonctionnellement les sources de lumière (10) et les composants électroniques de pilotage (30).

7. Dispositif d'éclairage (1000) selon l'une quelconque des revendications précédentes, dans lequel les sources de lumière à semi-conducteurs (10) comprennent des puces (12) ayant des aires de puce (A) d'au maximum 1 mm².

8. Dispositif d'éclairage (1000) selon l'une quelconque des revendications précédentes, dans lequel les k couches (110) comprennent chacune une pluralité de sources de lumière (10).

9. Dispositif d'éclairage (1000) selon la revendication 8, dans lequel au moins deux des k couches (110) comprennent chacune un sous-ensemble (210) de sources de lumière (10) de la pluralité respective de sources de lumière (10), dans lequel les sources de lumière (10) au sein de chaque sous-ensemble respectif (210) sont choisies parmi un même compartiment et dans lequel les sources de lumière (10) de sous-ensembles différents (210) de couches différentes (110) sont choisies parmi des compartiments différents.

10. Dispositif d'éclairage (1000) selon l'une quelconque des revendications précédentes, comprenant en outre un matériau luminescent (50) configuré en aval d'une ou plusieurs parmi le nombre total de sources de lumière à semi-conducteurs (10), dans lequel le matériau luminescent (50) est configuré pour convertir au moins une partie de la lumière de source de lumière (11) des sources de lumière à semi-conducteurs (10) configurées en amont du matériau luminescent (50) en lumière de matériau luminescent (51).

11. Dispositif d'éclairage (1000) selon la revendication 10, dans lequel un ou plusieurs de ce qui suit s'applique : (i) le matériau luminescent (50) est compris par un trou de PCB (220) selon la revendication 3 en aval de celle ou de celles parmi le nombre total de sources de lumière à semi-conducteurs (10) et (ii) n>2 et une ou plusieurs des couches (110) comprennent le matériau luminescent (50).

12. Dispositif d'éclairage (1000) selon l'une quelconque des revendications précédentes, dans lequel le dispositif d'éclairage (1000) est configuré pour générer de la lumière de dispositif d'éclairage (1001) qui comprend une ou plusieurs (i) parmi la lumière de source de lumière (11) d'une ou plusieurs des sources de lumière (10) et (ii) la lumière de matériau luminescent (51) selon l'une quelconque des revendications 10 à 11 précédentes.

13. Luminaire (1100) comprenant le dispositif d'éclairage (1000) selon l'une quelconque des revendications 1 à 12 précédentes.

14. Système d'éclairage (1200) comprenant (i) le dispositif d'éclairage (1000) selon l'une quelconque des revendications 1 à 12 précédentes et (ii) un système de commande (60) configuré pour commander les composants électroniques de pilotage (30) selon l'une quelconque des revendications 4 à 6 précédentes, dans lequel le système de commande (60) est configuré pour amener le dispositif d'éclairage (1000) à générer une ou plusieurs parmi (a) de la lumière blanche de système d'éclairage (1201) dans un premier mode de commande et (b) de la lumière colorée de système (1201) dans un deuxième mode de commande.

15. Procédé de fourniture du dispositif d'éclairage (1000) selon l'une quelconque des revendications 1 à 12 précédentes, le procédé comprenant l'empilement de n couches (110), dans lequel n≥2, dans lequel k couches (110) des n couches empilées (110) comprennent chacune une PCB (200) avec une source de lumière à semi-conducteurs (10), dans lequel 2≤k≤n, dans lequel les sources de lumière à semi-conducteurs (10) sont configurées pour générer de la lumière de source de lumière (11), dans lequel :
- un ou plusieurs de ce qui suit s'applique : (i) une ou plusieurs des k couches (110) comprennent un ou plusieurs trous de couche (120) et (ii) la création dans une phase de création de trou d'un ou plusieurs trous de couche (120) dans une ou plusieurs des k couches (110) des n couches empilées (110) après l'empilement ;
- ce qui suit s'applique : (iii) l'empilement des n couches (110) et (iv) la création facultative d'un trou de couche (120) des trous de couche (120) dans la phase de création de trou est telle que du fait de l'alignement des sources de lumière (10) et des trous de couche (120) la lumière de source de lumière (11) d'une source de lumière (10) de l'une quelconque des PCB (200) soit au moins partiellement non bloquée physiquement par l'une quelconque des autres PCB (200),
- une plus petite PCB dans la couche (110) sur la couche (11) comprenant la source de lumière à semi-conducteurs (10) est appliquée.
